# EUROPEAN PATENT SPECIFICATION

(11) **EP 2 852 982 B1**
(45) Date of publication and mention of the grant of the patent: **29.06.2016**
(21) Application number: 13723153.6
(22) Date of filing: 16.05.2013
(51) Int. Cl.: H01L 31/048

(54) **SOLAR PANEL MODULE AND ASSEMBLY**
SOLARPLATTENMODUL UND ANORDNUNG
MODULE ET ENSEMBLE DE PANNEAU SOLAIRE

(30) Priority: 22.05.2012 NL 2008853
(43) Date of publication of application: 01.04.2015
(73) Proprietor: Mate4Sun B.v., 6419 DJ Heerlen (NL)
(72) Inventor: VAN HESE, Alfred Gerardus, NL-6369 GX Simpelveld (NL); PHILIPSE-VERHAGEN, Esther Johanna Maria Gertruda, NL-5611 HZ Eindhoven (NL)
(74) Representative: Veldman-Dijkers, Cornelia G. C.
(86) International application number: PCT/EP2013/060194
(87) International publication number: WO 2013/174724

(56) References cited:
- GB-A- 2 463 335
- US-A1- 2007 199 590
- US-A1- 2010 242 381

## Description

The invention relates to a solar panel module comprising a first and a second cover plate as well as at least one photovoltaic cell located between the cover plates.

The invention further relates to an assembly of at least a first solar panel module and a second solar module according to the invention.

Such a solar panel module is already known from US 4,210,462. Documents GB 2 463 335 A and US2007/199590 disclose photolvoltaic panels. This document discloses a laminated solar panel that on both outer sides of the panel comprises a glass-like material. Between the two outer sides of the panel a layer of photovoltaic cells has been applied. The whole is pressed together under vacuum and high pressure and bonded with glue, by which a single solar panel module is formed. Along the edges of the solar panel module a circumferential ring can be placed for protection against shocks and influences from outside.

It is a disadvantage of the above-mentioned solar panel module that this solar panel module has to be placed detachedly on top of a conventional surface, for example on a - whether or not - flat roof. It is also not possible by means of these solar modules that are placed on a surface, to connect multiple solar panels with each other aesthetically pleasing and watertight, i.e. space should be kept between the solar panel modules for the edges of the solar panel modules.

It is an object of the present invention to provide a solar panel that can be manufactured with parts that have been manufactured by means of conventional technologies, with which also the conventional standard panels are manufactured. It is also an object of the invention to provide a solar panel module that is easily linkable with other solar panel modules into an assembly of modules.

This object is achieved by the solar panel modules according to the invention in that the first cover plate and the second cover plate are staggered relative to each other, wherein a portion of the first cover plate near a first longitudinal side extends beyond a first longitudinal side of the second cover plate, while a portion of the second cover plate near a second longitudinal side, which is extending parallel to the first longitudinal side, extends beyond a second longitudinal side of the first cover plate, which is extending parallel to the first longitudinal side, wherein the photovoltaic cell is located between the first longitudinal side of the second cover plate and the second longitudinal side of the first cover plate.

The staggered cover plates have the effect that a number of plates can be easily attached to each other in order to obtain a continuous, composite panel. When two solar panel modules are placed adjacently on a subsurface, such as for instance a roof of a building, the portion of the first cover plate of the first solar panel module, which portion is located near the first longitudinal side is in contact with the portion of the second cover plate of the second solar panel module, which portion located on the second longitudinal side. By such a placement the first and second solar panel module lie close to each other and form therefore a closed surface, entirely made up of solar panel modules, in the direction from the first to the second longitudinal side.

In the direction transverse thereto, the solar panel modules can be laid over each other like roof tiles, that is to say with an overlap, in order to guarantee a good drainage.

Between the solar modules that are connected to each other, only very small open spaces and/or open seams are present, so that surface shaped by the solar panel modules forms an aesthetic whole, which is particularly advantageous when the shaped surface is part of a roof construction of a building.

It is noted that in this patent application, by the first cover plate is meant the cover plate that is placed on the side of the solar panel module that, in operation, is directed towards the sun. By the second cover plate is meant the cover plate that is placed on the side of the solar panel module that, in operation, is directed towards the side averted from the sun.

The photovoltaic cell located between the first cover plate and the second cover plate is protected against influences from outside by the first cover plate and the second cover plate. By external influences are meant e.g. rain, hail and other types of precipitation, as well as wind and solids carried by the wind such as leaves, branches and even stones.

It is noted that US2007/157963A1 already discloses photovoltaic cells integrated in a roof tile, which roof tiles are attachable to one another. The document discloses a roof tile, which comprises a recess in which photovoltaic cells can be accommodated. The photovoltaic cells are mounted in the recess of the roof tile since, by using a casting process, a liquid transparent plastic is applied on the cells. On the backside of the roof tile a framework is provided that is integrally formed during a casting process. The framework provides in a coupling of the roof tile with an adjacent roof tile. The roof tile does not include cover plates staggered with respect to each other for the attachment of a second adjacent solar panel module.

An embodiment of the solar panel module according to the invention is characterized in that a portion of the first cover plate near a third longitudinal side, which is extending substantially transverse to the first longitudinal side, extends beyond a third longitudinal side of the second cover plate, while a portion of the second cover plate near a fourth longitudinal side, which is extending parallel to the third longitudinal side, extends beyond a fourth longitudinal side of the first cover plate, which is extending parallel to the third longitudinal side, wherein the photovoltaic cell is located between the third longitudinal side of the second cover plate and the fourth longitudinal side of the first cover plate.

Because of the juxtaposition of various solar panel modules, wherein the portion near the third longitudinal side of the first cover plate of a first solar panel module is connected to the portion located near the fourth longitudinal side of a second cover plate of a second solar panel module, only very minor open spaces and/or open seams are present between the mounted solar panel modules.

Such a surface area of solar panel modules placed adjacent to each other, for example resulting in a flat roof with only very minor open spaces and/or open seams, contributes to an aesthetic whole of a surface, in particular when applied on a roof of a building. The whole surface covered with solar panel modules will then have an optically homogeneous appearance.

It should be noted that the parts of a surface not covered with solar panel modules could be provided with fitting panels that fill these parts. These panels can be designed in such a way that they are optically equivalent and are equivalent to the solar panel modules with regard to protection against influences from outside. This allows the entire surface to obtain the same optical appearance. The fitting panels can include any potential surface shape.

An embodiment of the solar panel module according to the invention is characterized in that the first cover plate has at least substantially the same coefficient of expansion as the second cover plate.

The solar panel modules according to the invention are exposed to huge temperature variations, ranging from very hot in summer conditions to very cold in winter conditions. Because of this difference in temperature, the first and the second cover plate of a solar panel module will expand and shrink. When the expansion or shrinkage between the first and the second cover plate is not at least substantially equal, the first cover plate will be shifted relative to the second cover plate, which may lead to cracks in joints between cover plates or cracking of the cover plates themselves.

The abovementioned very small open spaces or open seams are applied between two adjacent solar panel modules, and are meant for adjustment in case of shrinkage or expansion of the cover plates and/or of occurring tolerance differences in the dimensions of the cover plates.

An embodiment of the solar panel module according to the invention is characterized in that the first cover plate and the second cover plate are at least substantially congruent.

When the first cover plate and the second cover plate have a congruent shape, then the first and the second cover plate are identical and the external dimensions of the first cover plate are accordingly equal to the external dimensions of the second cover plate. Equal external dimensions are advantageous because with a first cover plate staggered relative to the second cover plate, a displacement over a given distance of the first respectively third longitudinal side of the first cover plate results in a displacement over the same distance of the second respectively fourth longitudinal side of the second cover plate. As a result, the solar panel modules are easily linkable.

An embodiment of the solar panel module according to the invention is characterized in that around the photovoltaic cell a circumferential seal is provided, which circumferential seal is in contact with the first cover plate and the second cover plate.

The photovoltaic cell disposed in the solar panel module is not, or not well enough, resistant to liquids and vapour. A circumferential seal that on the one hand abuts against the first cover plate and on the other hand abuts against the second cover plate seals the photovoltaic cell off airtight and liquid-tight. The seal may include a resin, a kit, or a plastic, and may be simultaneously laminated during the manufacturing process of a solar panel module. The circumferential seal is applied in a portion of the solar panel module in which both a first cover plate and a second cover plate are present. The circumferential seal serves as adjustment in case of a possible difference in the coefficient of expansion between the first cover plate and the second cover plate.

An embodiment of the solar panel module according to the invention is characterized in that the second cover plate comprises at least one recess for the passage of electric wires from the photovoltaic cell to an outer side, wherein the recess is applied within a perimeter defined by the circumferential seal.

Photovoltaic cells generate a direct current, which must be discharged from the solar panel module. This requires a connection to be made on or to the solar panel module. The recess is applied within the perimeter, which is defined by the circumferential seal, so that in a simple manner a passage is made from the photovoltaic cell to the outside.

This connection is placed in the recess in the second cover plate, which has the result that the portions near the longitudinal sides of the cover plates can stay clear of electric wires. The side of the second cover of the solar panel module, which during operation is averted from the sun, is the side that is least affected by influences from outside. The probability of the occurrence of leakage, by which fluid can enter into the solar panel module, is minimized by positioning the recess on this side.

An embodiment of the solar panel module according to the invention is characterized in that the solar panel module comprises various photovoltaic cells and in that in the recess the electrical wires of the various photovoltaic cells coincide.

If various photovoltaic cells, or groups of photovoltaic cells are applied in a solar panel module, then the positive connection and the negative connection of each of the photovoltaic cells or groups of cells are conducted to the same recess, where these coincide. A single recess in the second cover plate can comprise both the wires for the positive pole and the wires for the negative pole. It is also possible to provide a second recess, wherein in the first recess all the negative poles present in the solar panel module coincide and in the second all the positive poles present in the solar panel module coincide.

An embodiment of the solar panel module according to the invention is characterized in that in the recess fastening means are provided for the attachment of electrical wiring and/or a current converter.

The recess may be provided with means for the attachment of electrical wiring, such as a clamping connection or a screw connection. Such connections facilitate the work of the person assembling the panels.

An embodiment of the solar panel module according to the invention is characterized in that the recess is sealed off with a watertight seal.

After the electrical wiring is attached, care should be taken that no liquid, such as rain, can enter into the solar panel module. Therefore, the recess is sealed off with a seal. This seal is preferably a flexible seal, made of a material like a resin, a (silicone) kit or a flexible plastic.

An embodiment of the solar panel module according to the invention is characterized in that at least the first cover plate includes transparent glass and/or transparent plastic.

Glass has a very good clearness, so that a yield of a solar panel module is usually higher than when the cover plate is made of a plastic. Glass is also especially scratch-resistant. Plastic, on the other hand, has the advantage that the cover plates can be carried out lighter than in glass and are less fragile.

When the cover plate is made from a laminate material comprising one or more layers of glass and one or more layers of plastic, then the result is a cover plate that is highly resistant to damage. When a glass layer is broken, a plastic layer still provides a watertight connection.

An embodiment of the solar panel module according to the invention is characterized in that the portions located near the longitudinal sides are provided with a flexible seal.

When two solar panel modules are attached to one another to form a tight connection, the portion of the first cover plate of the first solar panel module near the first longitudinal side is pressed against the portion of a second cover plate of the second solar panel module near the second longitudinal side portion. In order to increase the water-tightness of the connection, a seal is provided between the two portions. Such a seal can include a resin, a (silicone) kit or a flexible plastic.

The seal can be attached to the portion of the first solar panel module as well as to the portion of the second solar panel module. A seal on both portions increases the water-tightness between the two solar panel modules even more.

The invention further relates to an assembly of at least a first solar panel module and a second solar panel module according to the invention.

The assembly is characterized in that the first solar panel module and the second solar panel module are connected to a current convertor for converting direct current to alternating current.

Such an assembly can be easily connected to an electrical installation in a building, so that an electric energy that is generated by the solar panel modules is immediately available for use.

Any of this will be clarified with reference to the following figures, in which:
Fig. 1 is a plan view of the solar panel module according to the invention;
Fig. 2 is a cross-sectional view of the solar panel module of Fig. 1;
Fig. 3 is a schematic cross-sectional view of a detail of extending longitudinal sides of two adjacent solar panel modules;
Fig. 4A is a schematic view of a part of the solar panel module shown in Fig. 1; and
Fig. 4B is a schematic cross-sectional view of the part shown in Fig. 4A.

In the figures, corresponding parts are indicated by the same reference numerals.

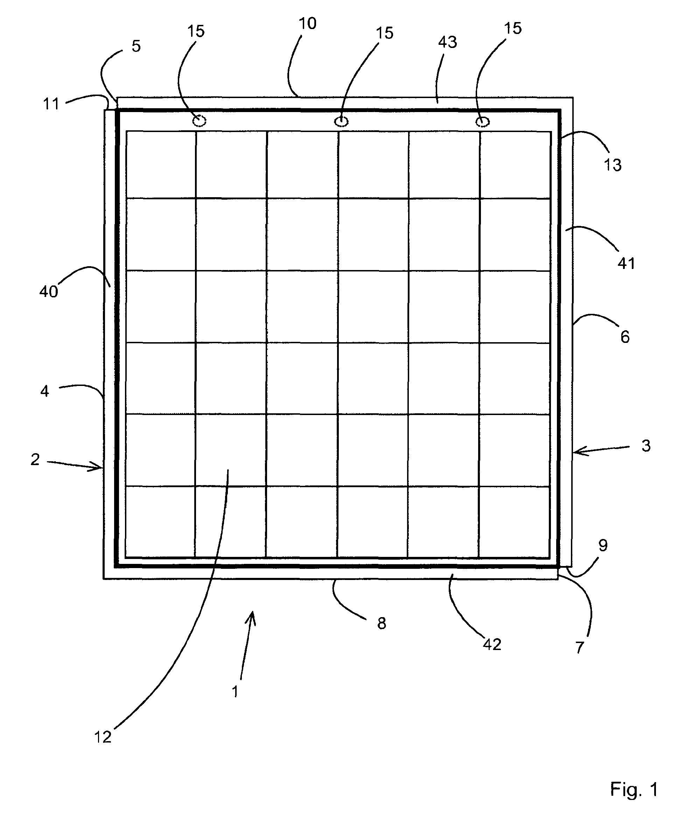

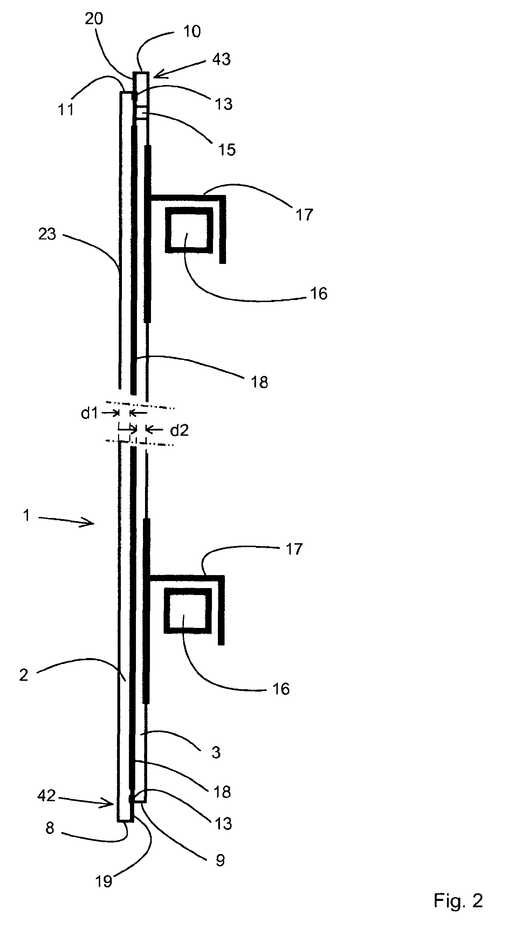

Figures 1 and 2 show a solar panel module 1 according to the invention. The solar panel module 1 comprises a first cover plate 2 and a second cover plate 3 placed below the first cover plate 2. The first cover plate 2 and the second cover plate 3 are staggered relative to each other. A portion 40 of the first cover plate 2 near a first longitudinal side 4 extends beyond a first longitudinal side 5 of the second cover plate 3, while a portion 41 of the second cover plate 3, located near a second longitudinal side 6 extending parallel to a first longitudinal side 5, extends beyond a second longitudinal side 7 of the first cover plate 2 extending parallel to the first longitudinal side.

A portion 42 of the first cover plate 2 near the third longitudinal side 8 extends beyond a third longitudinal side 9 of the second cover plate 3. A portion 43 extending parallel to the third longitudinal side 8 near the fourth longitudinal side 10 of the second cover plate extends beyond the fourth longitudinal side 11 of the first cover plate 2.

The longitudinal sides 5, 7, 9, 11 define a surface 12, on which the photovoltaic cell or the groups of photovoltaic cells are placed between both cover plates 2, 3. Between the two cover plates 2, 3 a seal 13 is applied at the level of the longitudinal sides 5, 7, 9, 11, which seal is in contact with both cover plates 2, 3. The seal 13 is provided along the entire perimeter of the surface 12 which is defined by the longitudinal sides 5, 7, 9, 11.

Cover plate 2 and cover plate 3 have the same shape and substantially the same dimensions, which has the result that when shifting the cover plates 2, 3 relative to each other, the distance between the longitudinal side 6 and the longitudinal side 7 corresponds with the distance between the longitudinal side 4 and the longitudinal side 5, and that the distance between the longitudinal side 8 and the longitudinal side 9 corresponds with the distance between the longitudinal side 10 and the longitudinal side 11. Accordingly, the portion 41 has the same shape and dimensions as the portion 40, and the portion 42 also has the same shape and dimensions as the portion 43.

The portion 42 of the first cover plate 2 forms an overhang, which extends beyond the longitudinal side 9 of cover plate 3. In addition, the portion 43 of the cover plate 3, which also forms an overhang, extends along the longitudinal side 11 of cover plate 2. When several solar panel modules 1 are placed adjacently, the surface 19 of a first overhang 42 of the first cover plate 2 of a first solar panel module 1 is in contact with a surface 20 of a second overhang 43 of the second cover plate 3 of a second solar panel module 1.

The distance between the longitudinal side 8 and the longitudinal side 9 and the distance between the longitudinal side 10 and the longitudinal side 11 form respectively the portions 42 and 43, which ensure that, with the juxtaposition of multiple solar panel modules, a surface is obtained with only very small open spaces and/or open seams. If all juxtaposed first cover plates 2 have the same thickness d1 and all juxtaposed second cover plates 3 have the same thickness d2, then the surfaces 23 of adjacent solar panel modules, being the sun facing sides 23 of the first cover plates 2, fit up closely to each other.

It is noted that an assembly of solar panel modules 1 does not necessarily have to be placed upon existing, conventional roofing. Due to the sealing action of the assembly of solar panel modules 1**,** the assembly can be directly connected to a roof rafter. The application of roofing at the location of the mounted solar panel modules 1 has then become redundant.

To the second cover plate 3 brackets 17 are attached, which brackets 17 can co-operate with suspension rails 16 that are attached to a subsurface. This subsurface may, for example, be a roof rafter of a building like a house. The brackets 17 can be locked by means of a locking mechanism (not shown). This prevents the separation of the brackets 17 from the suspension rails 16 under e.g. bad weather conditions.

In the second cover plate 3, at the side averted from the sun, three recesses 15 have been provided for the passage of electric contacts from the photovoltaic cell 18 to an outer side. The recesses in the present embodiment are through-holes that, in operation, run from the sun facing side of the second cover plate 3 to the side of the second cover plate 3 that is averted from the sun.

The recess 15 is provided within surface 12 that is defined by the longitudinal sides 5, 7, 9, 11 and within the peripheral boundary of the circumferential seal 13, which is placed against the longitudinal sides 5, 7, 9, 11. When the solar panel module 1 is in operation, the recess 15 is sealed by a seal (not shown), which seals off the entire recess 15 airtight and liquid-tight, in order to prevent short-circuiting in photovoltaic cells 18.

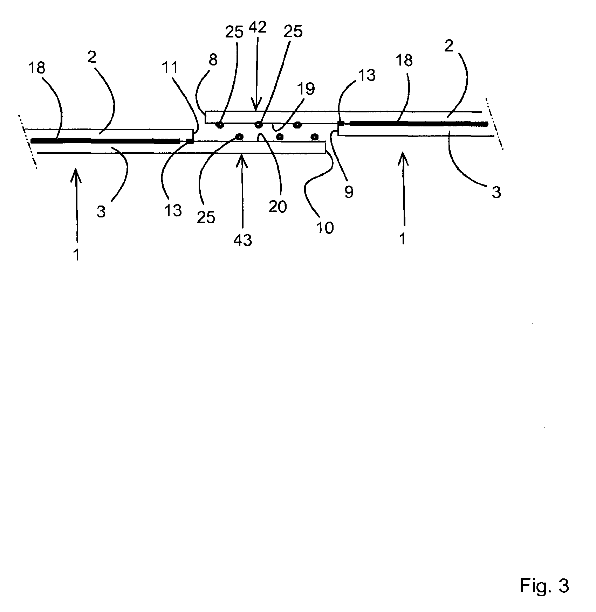

Figure 3 shows a schematic enlarged cross-sectional view of extending portions 42, 43 of two adjacent solar panel modules 1. Each solar panel module 1 comprises a first cover plate 2 and a second cover plate 3. Between the first cover plates 2 and the second cover plates 3 a photovoltaic cell 18 is applied. Between the first cover plate 2 and the second cover plate 3, the circumferential seal 13 is provided between the photovoltaic cell 18 and the longitudinal side 9 respectively 11, in order to prevent water inlet at the photovoltaic cell 18.

During the juxtaposition of the various solar panel modules 1, portion 42 and portion 43 are positioned opposite one another in such a way that the surface 19 of the first cover plate 2 and the surface 20 of the second cover plate 3 are turned towards one another. On both surfaces 19 and 20 flexible seals 25 are applied at the level of the portions 42 and 43. In order to obtain a maximum watertight seal, it is also possible to place a flexible seal between the longitudinal sides 11 and 8 and between the longitudinal sides 9 and 10. The flexible seal 25 may be a liquid sealant, which is applied in liquid state, and which cures thereafter. Also, the seal 25 may be a solid sealant, which is applied between the surfaces 19 and 20 and which provides a seal by means of compression between the two surfaces 19, 20.

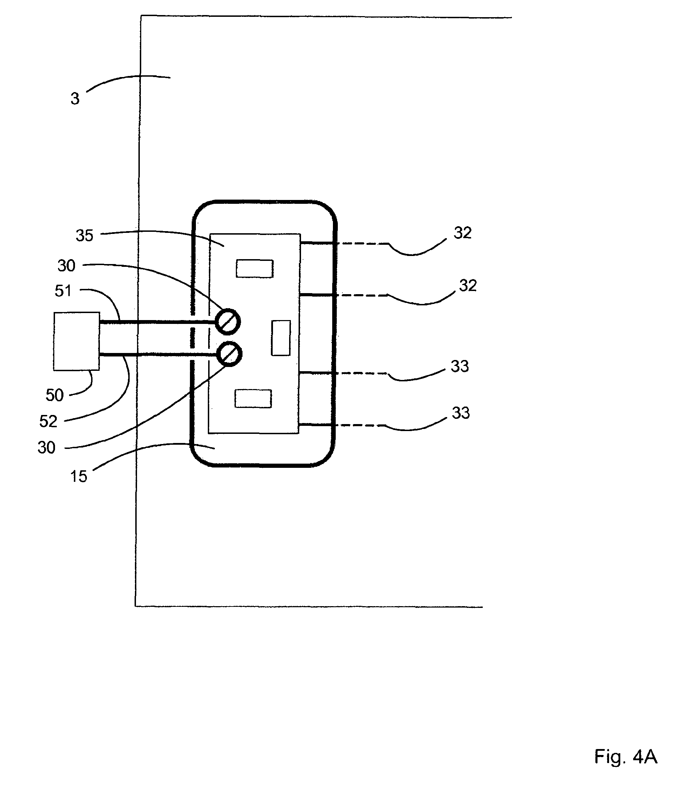

Figure 4A shows a schematic detailed view of a recess 15 from Fig. 1. In the recess 15 a contact plate 35 is provided in the cover plate 3, on which the electric wires 32 and 33 are placed which, respectively, are coming from a first group of photovoltaic cells 18 and a second group of photovoltaic cells 18. The electric wires are attached to the contact plate 35, for example by means of soldering.

The contact plate 35 further includes fastening means 30 for attachment of electrical wiring 51, 52 leading to the outside. Due to this electrical wiring 51, 52 the solar panel module 1 can be connected with a current convertor 50 which converts direct current that is generated by the photovoltaic cells 18 to alternating current.

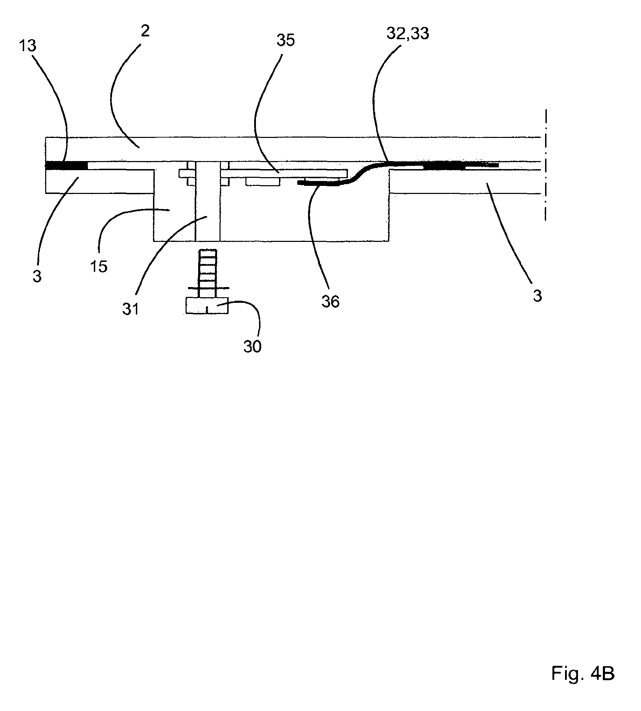

Figure 4B shows a cross-sectional view of the portion shown in Fig. 4A. Figure 4B shows the first cover plate 2 and the second cover plate 3 and the recess 15 located therein. In the recess 15 the contact plate 35 is fitted, which on one side thereof comprises connecting means 36 for receiving the electric wires 32, 33, and which on an opposite side of the contact plate 35 comprises the fastening means 30, 31 for attachment of the electrical wires 51, 52 that lead to the outside.

The fastening means 30, 31 include a bolt 30 which may be screwed in a holder 31, which holder is provided with a screw thread. The electric wiring 51, 52 can be fixed with the aid of the bolt 30, so as make contact with the connecting means 36. The person who will install the solar panel module 1 on site can perform this operation.

The fastening means 30, 31 can also include any other fastening means, such as, for example, a clamping connection.

It is also possible that in cases where the solar panel modules are laid over each other like overlapping roof tiles, portions of the first cover plate 2 near the third longitudinal side 8 as well as near the the fourth longitudinal side 11 of the first cover plate 2 may extend beyond a third longitudinal side 9 respectively the fourth longitudinal side 10 of the second cover plate 3. With such an embodiment a portion of the first cover plate 2 near a first longitudinal side 4 extends beyond a first longitudinal side 5 of the second cover plate 3, while a portion of the second cover plate 3 near a second longitudinal side 6 extends beyond a second longitudinal side 7 of the first cover plate 2. The distance between the first and second longitudinal side 4, 7 of the first plate 2 is the same as the distance between the first and second longitudinal side 5, 6 of the second plate 3.

It is also possible to provide a passage for the electric wires from the photovoltaic cell to an outer side between the two plates 2, 3.

## Claims

1. Solar panel module (1) comprising a first and a second cover plate (2, 3), and at least one photovoltaic cell (18), located between the cover plates (2, 3), **characterized in that** the first cover plate (2) and the second cover plate (3) are staggered relative to each other, wherein a portion (40) of the first cover plate (2) near a first longitudinal side (4) extends beyond a first longitudinal side (5) of the second cover plate (3), while a portion (41) of the second cover plate (3) near a second longitudinal side (6), which is extending parallel to the first longitudinal side (4), extends beyond a second longitudinal side (7) of the first cover plate (2), which is extending parallel to the first longitudinal side, wherein the photovoltaic cell (18) is located between the first longitudinal side (5) of the second cover plate (3) and the second longitudinal side (7) of the first cover plate (2).

2. Solar panel module (1) according to claim 1, **characterized in that** a portion (42) of the first cover plate (2) near a third longitudinal side (8), which is extending substantially transverse to the first longitudinal side (4), extends beyond a third longitudinal side (9) of the second cover plate (3), while a portion (43) of the second cover plate (3) near a fourth longitudinal side (10), which is extending parallel to the third longitudinal side (9), extends beyond a fourth longitudinal side (11) of the first cover plate (2), which is extending parallel to the third longitudinal side (9), wherein the photovoltaic cell (18) is located between the third longitudinal side (9) of the second cover plate (3) and the fourth longitudinal side (11) of the first cover plate (2).

3. Solar panel module (1) according to any of the preceding claims, **characterized in that** the first cover plate (2) has at least substantially the same coefficient of expansion as the second cover plate (3).

4. Solar panel module (1)according to any of the preceding claims, **characterized in that** the first cover plate (2) and the second cover plate (3) are at least substantially congruent.

5. Solar panel module (1) according to any of the preceding claims, **characterized in that** around the photovoltaic cell (18) a circumferential seal (13) is provided, which circumferential seal (13) is in contact with the first cover plate (2) and the second cover plate (3).

6. Solar panel module (1) according to claim 5, **characterized in that** the second cover plate (3) comprises at least one recess (15) for the passage of electric wires (32, 33) from the photovoltaic cell (18) to an outer side, wherein the recess (15) is applied within a perimeter defined by the circumferential seal (13).

7. Solar panel module (1) according to claim 6, **characterized in that** the solar panel module (1) comprises various photovoltaic cells (18) and **in that** in the recess (15) the electric wires (32, 33) of the various photovoltaic cells (18) coincide.

8. Solar panel module (1) according to claim 6 or 7, **characterized in that** in the recess (15) fastening means (30) are provided for the attachment of electric wiring and/or a current convertor.

9. Solar panel module (1) according to any of the claims 6 - 8, **characterized in that** the recess (15) is sealed off with a watertight seal.

10. Solar panel module (1) according to one of the preceding claims, **characterized in that** at least the first cover plate (2) comprises transparent glass and/or transparent plastic.

11. Solar panel module (1) according to any of the preceding claims, **characterized in that** the portions (40, 41, 42, 43) located near the longitudinal sides (4, 6, 8, 10) are provided with a flexible seal (25).

12. Assembly of at least a first solar panel module (1) and a second solar panel module (1) according to one of the preceding claims, **characterized in that** the first solar panel module (1) and the second solar panel module (1) are connected with a current convertor for converting direct current to alternating current.

## Patentansprüche

1. Solarpaneelmodul (1), das eine erste und eine zweite Deckplatte (2, 3) und mindestens eine zwischen den Deckplatten (2, 3) angeordnete Photovoltaikzelle (18) umfasst, **dadurch gekennzeichnet, dass** die erste Deckplatte (2) und die zweite Deckplatte (3) relativ zueinander versetzt sind, wobei ein Abschnitt (40) der ersten Deckplatte (2) in der Nähe einer ersten Längsseite (4) sich über eine erste Längsseite (5) der zweiten Deckplatte (3) hinaus erstreckt, während ein Abschnitt (41) der zweiten Deckplatte (3) in der Nähe einer zweiten Längsseite (6), die sich parallel zu der ersten Längsseite (4) erstreckt, sich über eine zweite Längsseite (7) der ersten Deckplatte (2) hinaus erstreckt, die sich parallel zu der ersten Längsseite erstreckt, wobei die Photovoltaikzelle (18) zwischen der ersten Längsseite (5) der zweiten Deckplatte (3) und der zweiten Längsseite (7) der ersten Deckplatte (2) angeordnet ist.

2. Solarpaneelmodul (1) gemäß Anspruch 1, **dadurch gekennzeichnet, dass** ein Abschnitt (42) der ersten Deckplatte (2) in der Nähe einer dritten Längsseite (8), die sich im Wesentlichen quer zu der ersten Längsseite (4) erstreckt, sich über eine dritte Längsseite (9) der zweiten Deckplatte (3) hinaus erstreckt, während ein Abschnitt (43) der zweiten Deckplatte (3) in der Nähe einer vierten Längsseite (10), die sich parallel zu der dritten Längsseite (9) erstreckt, sich über eine vierte Längsseite (11) der ersten Deckplatte (2) hinaus erstreckt, die sich parallel zu der dritten Längsseite (9) erstreckt, wobei die Photovoltaikzelle (18) zwischen der dritten Längsseite (9) der zweiten Deckplatte (3) und der vierten Längsseite (11) der ersten Deckplatte (2) angeordnet ist.

3. Solarpaneelmodul (1) gemäß einem der vorstehenden Ansprüche, **dadurch gekennzeichnet, dass** die erste Deckplatte (2) mindestens im Wesentlichen denselben Ausdehnungskoeffizienten wie die zweite Deckplatte (3) hat.

4. Solarpaneelmodul (1) gemäß einem der vorstehenden Ansprüche, **dadurch gekennzeichnet, dass** die erste Deckplatte (2) und die zweite Deckplatte (3) mindestens im Wesentlichen kongruent sind.

5. Solarpaneelmodul (1) gemäß einem der vorstehenden Ansprüche, **dadurch gekennzeichnet, dass** um die Photovoltaikzelle (18) eine umlaufende Dichtung (13) vorgesehen ist, wobei die umlaufende Dichtung (13) mit der ersten Deckplatte (2) und der zweiten Deckplatte (3) in Berührung steht.

6. Solarpaneelmodul (1) gemäß Anspruch 5, **dadurch gekennzeichnet, dass** die zweite Deckplatte (3) mindestens eine Ausnehmung (15) zum Durchführen von elektrischen Leitungen (32, 33) von der Photovoltaikzelle (18) zu einer Außenseite umfasst, wobei die Ausnehmung (15) innerhalb eines durch die umlaufende Dichtung (13) bestimmten Umfangs eingebracht ist.

7. Solarpaneelmodul (1) gemäß Anspruch 6, **dadurch gekennzeichnet, dass** das Solarpaneelmodul (1) verschiedene Photovoltaikzellen (18) umfasst und dass in der Ausnehmung (15) die elektrischen Leitungen (32, 33) der verschiedenen Photovoltaikzellen (18) zusammentreffen.

8. Solarpaneelmodul (1) gemäß Anspruch 6 oder 7, **dadurch gekennzeichnet, dass** in der Ausnehmung (15) Befestigungsmittel (30) zum Anschluss von elektrischen Leitungen und/oder einem Stromwandler vorgesehen sind.

9. Solarpaneelmodul (1) gemäß einem der Ansprüche 6 - 8, **dadurch gekennzeichnet, dass** die Ausnehmung (15) mit einer wasserdichten Dichtung abgedichtet ist.

10. Solarpaneelmodul (1) gemäß einem der vorstehenden Ansprüche, **dadurch gekennzeichnet, dass** mindestens die erste Deckplatte (2) transparentes Glas und/oder transparenten Kunststoff umfasst.

11. Solarpaneelmodul (1) gemäß einem der vorstehenden Ansprüche, **dadurch gekennzeichnet, dass** die in der Nähe der Längsseiten (4, 6, 8, 10) angeordneten Abschnitte (40, 41, 42, 43) mit einer flexiblen Dichtung (25) versehen sind.

12. Anordnung aus mindestens einem ersten Solarpaneelmodul (1) und einem zweiten Solarpaneelmodul (1) gemäß einem der vorstehenden Ansprüche, **dadurch gekennzeichnet, dass** das erste Solarpaneelmodul (1) und das zweite Solarpaneelmodul (1) mit einem Stromwandler zum Wandeln von Gleichstrom in Wechselstrom verbunden sind.

## Revendications

1. Module de panneau solaire (1) comprenant une première et une deuxième plaque de couverture (2, 3) et au moins une cellule photovoltaïque (18), située entre les plaques de couverture (2,3), **caractérisé en ce que** la première plaque de couverture (2) et la deuxième plaque de couverture (3) sont décalées l'une par rapport à l'autre, dans lequel une portion (40) de la première plaque de couverture (2) proche d'un premier bord longitudinal (4) s'étend au-delà d'un premier bord longitudinal (5) de la deuxième plaque de couverture (3), alors qu'une portion (41) de la deuxième plaque de couverture (3) proche d'un deuxième bord longitudinal (6), qui s'étend parallèlement au premier bord longitudinal (4), s'étend au-delà d'un deuxième bord longitudinal (7) de la première plaque de couverture (2), qui s'étend parallèlement au premier bord longitudinal, dans lequel la cellule photovoltaïque (18) est située entre le premier bord longitudinal (5) de la deuxième plaque de couverture (3) et le deuxième bord longitudinal (7) de la première plaque de couverture (2).

2. Module de panneau solaire (1) selon la revendication 1, **caractérisé en ce qu'**une portion (42) de la première plaque de couverture (2) proche d'un troisième bord longitudinal (8), qui s'étend sensiblement transversalement au premier bord longitudinal (4), s'étend au-delà d'un troisième bord longitudinal (9) de la deuxième plaque de couverture (3), alors qu'une portion (43) de la deuxième plaque de couverture (3) proche d'un quatrième bord longitudinal (10), qui s'étend parallèlement au troisième bord longitudinal (9), s'étend au-delà d'un quatrième bord longitudinal (11) de la première plaque de couverture (2), qui s'étend parallèlement au troisième bord longitudinal (9), dans lequel la cellule photovoltaïque (18) est située entre le troisième bord longitudinal (9) de la deuxième plaque de couverture (3) et le quatrième bord longitudinal (11) de la première plaque de couverture (2).

3. Module de panneau solaire (1) selon l'une quelconque des revendications précédentes, **caractérisé en ce que** la première plaque de couverture (2) a au moins sensiblement le même coefficient de dilatation que la deuxième plaque de couverture (3).

4. Module de panneau solaire (1) selon l'une quelconque des revendications précédentes, **caractérisé en ce que** la première plaque de couverture (2) et la deuxième plaque de couverture (3) sont au moins sensiblement congruentes.

5. Module de panneau solaire (1) selon l'une quelconque des revendications précédentes, **caractérisé en ce qu'**un joint d'étanchéité périphérique (13) est disposé autour de la cellule photovoltaïque (18), lequel joint d'étanchéité périphérique (13) est en contact avec la première plaque de couverture (2) et la deuxième plaque de couverture (3).

6. Module de panneau solaire (1) selon la revendication 5, **caractérisé en ce que** la deuxième plaque de couverture (3) comprend au moins un évidement (15) pour le passage de fils électriques (32, 33) de la cellule photovoltaïque (18) vers un côté extérieur, dans lequel l'évidement (15) est appliqué à l'intérieur d'un périmètre défini par le joint d'étanchéité périphérique (13).

7. Module de panneau solaire (1) selon la revendication 6, **caractérisé en ce que** le module de panneau solaire (1) comprend diverses cellules photovoltaïques (18) et **en ce que** les fils électriques (32, 33) des diverses cellules photovoltaïques (18) coïncident dans l'évidement (15).

8. Module de panneau solaire (1) selon la revendication 6 ou 7, **caractérisé en ce que** des moyens de fixation (30) sont disposés dans l'évidement (15) pour la fixation de câblage électrique et/ou d'un convertisseur de courant.

9. Module de panneau solaire (1) selon l'une quelconque des revendications 6 à 8, **caractérisé en ce que** l'évidement (15) est scellé avec un joint étanche.

10. Module de panneau solaire (1) selon l'une quelconque des revendications précédentes, **caractérisé en ce qu'**au moins la première plaque de couverture (2) comprend un verre transparent et/ou un plastique transparent.

11. Module de panneau solaire (1) selon l'une quelconque des revendications précédentes, **caractérisé en ce que** les portions (40, 41, 42, 43) situées près des côtés longitudinaux (4, 6, 8, 10) sont munies d'un joint flexible (25).

12. Ensemble d'au moins un premier module de panneau solaire (1) et un deuxième module de panneau solaire (1) selon l'une quelconque des revendications précédentes, **caractérisé en ce que** le premier module de panneau solaire (1) et le deuxième module de panneau solaire (1) sont connectés avec un convertisseur de courant pour convertir un courant continu en courant alternatif.
